# EUROPEAN PATENT SPECIFICATION

(11) **EP 3 966 888 B1**
(45) Date of publication and mention of the grant of the patent: **16.04.2025**
(21) Application number: 20839710.9
(22) Date of filing: 13.07.2020
(51) Int. Cl.: H01M 50/531, H01M 50/10, H01M 50/543, H01M 10/04, H01M 10/0587, H01M 10/052, H01M 50/105, H01M 50/557

(54) **BATTERY AND ELECTRONIC DEVICE INCLUDING SAME**
BATTERIE UND ELEKTRONISCHE VORRICHTUNG DAMIT
BATTERIE ET DISPOSITIF ÉLECTRONIQUE LA COMPORTANT

(30) Priority: 16.07.2019 KR 20190085950
(43) Date of publication of application: 16.03.2022
(73) Proprietor: Samsung Electronics Co., Ltd., Suwon-si, Gyeonggi-do 16677 (KR)
(72) Inventor: JEON, Yongsub, Suwon-si Gyeonggi-do 16677 (KR); JANG, Kiyoun, Suwon-si Gyeonggi-do 16677 (KR); SEO, Youngho, Suwon-si Gyeonggi-do 16677 (KR); YOON, Jongmoon, Suwon-si Gyeonggi-do 16677 (KR); LEE, Jaeyeon, Suwon-si Gyeonggi-do 16677 (KR)
(74) Representative: Gulde & Partner
(86) International application number: PCT/KR2020/009215
(87) International publication number: WO 2021/010716

(56) References cited:
- JP-A- 2001 176 488
- JP-A- 2013 187 077
- KR-A- 20180 037 786
- KR-A- 20180 054 038
- US-A1- 2006 166 088
- US-A1- 2019 036 148
- US-B2- 10 347 896

## Description

### Technical Field

The disclosure relates generally to a battery and an electronic device including the same.

### Background Art

As digital technologies have developed, electronic devices have been provided in various forms such as smartphones, tablet personal computers (PCs), or personal digital assistants (PDAs). The electronic devices have been developed to be portable or wearable by users, thereby improving portability and accessibility of the users. Typically, a portable or wearable electronic device includes a battery for supplying electric power.
Recent electronic devices have employed integral batteries for slimness rather than replaceable batteries. The performance (e.g., the output) of an integral battery may be different according to a configuration scheme of the electrode tabs. Accordingly, in order to maximize battery performance, the configuration scheme of the electrode tabs connected to a cathode and an anode may be an important factor. The US 2019/036148 A1 discloses a battery cell including a plurality of regularly protruding tabs respectively for anode and cathode, which overlap each other so as to be parallel to each other and are coupled to unit lead tabs. The US 10 347 896 B2 discloses a battery pack with pouch cells, wherein each pouch cell has a castellated tab to contact a bus bar for interconnecting different cells. Disclosure of Invention

### Technical Problem

Recent electronic devices have required batteries of higher capacity and higher output in order to support high performance modules (or electronic circuits) therein, such as for 5^{th} generation (5G) networks. In order to provide high capacity and high output, batteries have been designed to have relatively lower resistances by using a plurality of electrode tabs. However, a battery having a plurality of electrode tabs may increase the thickness of a battery cell as the plurality of electrode tabs overlap each other in the interior of the battery cell. An increase in the thickness of the battery cell may also increase the thickness of the electronic device. Further, when a thicker electronic device is not desired, the thickness of the battery cell cannot be increased, thus limiting the capacity of the battery.

As another example, a battery having a plurality of electrode tabs may be configured such that the electrode tabs are disposed in the interior of the battery cell such that they do not overlap each other and the electrode tabs exposed to the outside are coupled to each other as a single body. However, because the electrode tabs do not overlap each other, the coupling strength of the electrode tabs may be relatively weak. For example, the electrode tabs may be separated from each other due to an external impact, such as dropping the electronic device.

Accordingly, an aspect of the disclosure is to provide an electrode tab structure in which some areas of a plurality of electrode tabs located in the interior of a battery cell do not overlap each other and which can improve a coupling strength of other areas of the electrode tabs exposed to the outside.

### Solution to Problem

In accordance with the invention, a battery is provided according to claim 1.

In accordance with another aspect of the disclosure, an electronic device is provided according to claim 11.

### Advantageous Effects of Invention

According to the above-described embodiments, an increase in the thickness of the battery can be minimized by disposing the electrode tabs in the interior of the battery cell such that the electrode tabs do not overlap each other. Additionally, a battery of high capacity can be provided by securing a mounting space for a battery cell. Further, the electrode tabs can be prevented from being separated due to an external impact, such as a drop, by improving a coupling strength of the electrode tabs, thereby reinforcing battery safety.

### Brief Description of Drawings

The above and other aspects, features, and advantages of certain embodiments of the disclosure will be more apparent from the following description taken in conjunction with the accompanying drawings, in which:
FIG. 1 illustrates an electronic device in a network environment according to an embodiment;
FIG. 2 illustrates an electronic device according to an embodiment;
FIG. 3A illustrates an external appearance of a battery according to an embodiment;
FIG. 3B illustrates an internal structure of a battery according to an embodiment;
FIG. 4 illustrates a battery cell before rolling according to an embodiment;
FIG. 5 illustrates a cross-sectional view of a battery cell in a rolling state according to an embodiment;
FIG. 6 illustrates a structure and a welding location of an electrode tab according to an embodiment;
FIG. 7 illustrates a structure and a welding location of an electrode tab according to an embodiment;
FIG. 8 illustrates a structure and a welding location of an electrode tab according to an embodiment;
FIG. 9 illustrates a structure and a welding location of an electrode tab according to an embodiment;
FIG. 10 illustrates a structure and a welding location of an electrode tab according to an embodiment;
FIG. 11 illustrates a structure and a welding location of an electrode tab according to an embodiment;
FIG. 12A illustrates a coupling structure of a plurality of electrode tabs according to an embodiment;
FIG. 12B illustrates a coupling structure of a plurality of electrode tabs according to an embodiment;
FIG. 12C illustrates a coupling structure of a plurality of electrode tabs according to an embodiment;
FIG. 13A illustrates a battery cell before rolling according to an embodiment;
FIG. 13B illustrates a battery cell in a rolling state according to an embodiment; and
FIG. 14 illustrates a battery cell before stacking according to an embodiment.

### Best Mode for Carrying out the Invention

Hereinafter, various embodiments will be described with reference to the accompanying drawings. Although the disclosure provides specific embodiments illustrated in the drawings and described in detail with reference thereto, the disclosure is not limited to these specific embodiments. Therefore, it should be apparent to those skilled in the art that various changes and modifications of the embodiments described herein can be made without departing from the scope and spirit of the disclosure. In addition, descriptions of well-known functions and constructions are omitted for clarity and conciseness..

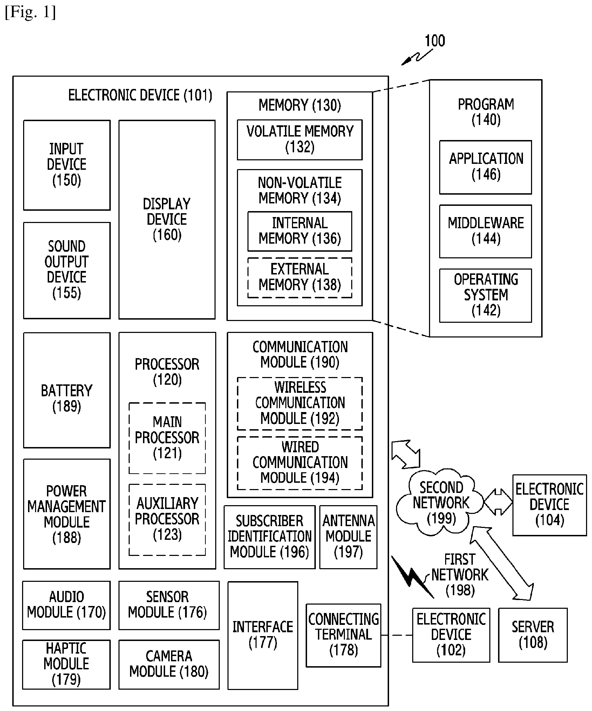

FIG. 1 illustrates an electronic device in a network environment according to an embodiment.

Referring to FIG. 1, an electronic device 101 in a network environment 100 may communicate with an electronic device 102 via a first network 198 (e.g., a short-range wireless communication network), or an electronic device 104 or a server 108 via a second network 199 (e.g., a long-range wireless communication network). The electronic device 101 may communicate with the electronic device 104 via the server 108. The electronic device 101 may include a processor 120, memory 130, an input device 150, a sound output device 155, a display device 160, an audio module 170, a sensor module 176, an interface 177, a haptic module 179, a camera module 180, a power management module 188, a battery 189, a communication module 190, a subscriber identification module (SIM) 196, and an antenna module 197. Alternatively, at least one of the components (e.g., the display device 160 or the camera module 180) may be omitted from the electronic device 101, or one or more other components may be added in the electronic device 101. Additionally, some of the components may be implemented as single integrated circuitry. For example, the sensor module 176 (e.g., a fingerprint sensor, an iris sensor, or an illuminance sensor) may be embedded in the display device 160 (e.g., a display).

The processor 120 may execute software (e.g., a program 140) to control at least one other component (e.g., a hardware or software component) of the electronic device 101 coupled with the processor 120, and may perform various data processing or computation. As at least part of the data processing or computation, the processor 120 may load a command or data received from another component (e.g., the sensor module 176 or the communication module 190) in volatile memory 132, process the command or the data stored in the volatile memory 132, and store resulting data in non-volatile memory 134. The processor 120 may include a main processor 121 (e.g., a central processing unit (CPU) or an application processor (AP)), and an auxiliary processor 123 (e.g., a graphics processing unit (GPU), an image signal processor (ISP), a sensor hub processor, or a communication processor (CP)) that is operable independently from, or in conjunction with, the main processor 121. Additionally or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display device 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). The auxiliary processor 123 (e.g., an image signal processor or a communication processor) may be implemented as part of another component (e.g., the camera module 180 or the communication module 190) functionally related to the auxiliary processor 123.

The memory 130 may store various data used by at least one component (e.g., the processor 120 or the sensor module 176) of the electronic device 101. The various data may include software (e.g., the program 140) and input data or output data for a command related thereto. The memory 130 may include the volatile memory 132 and the non-volatile memory 134.

The program 140 may be stored in the memory 130 as software, and include an operating system (OS) 142, middleware 144, or an application 146.

The input device 150 may receive a command or data to be used by another component (e.g., the processor 120) of the electronic device 101, from the outside (e.g., a user) of the electronic device 101. The input device 150 may include a microphone, a mouse, a keyboard, or a digital pen (e.g., a stylus pen).

The sound output device 155 may output sound signals to the outside of the electronic device 101. The sound output device 155 may include a speaker and/or a receiver. The speaker may be used for general purposes, such as playing multimedia or playing record, and the receiver may be used for an incoming calls. The receiver may be implemented separate from, or as part of the speaker.

The display device 160 may visually provide information to the outside (e.g., a user) of the electronic device 101. The display device 160 may include a display, a hologram device, or a projector and control circuitry to control a corresponding one of the display, hologram device, and projector. The display device 160 may include touch circuitry adapted to detect a touch, or sensor circuitry (e.g., a pressure sensor) adapted to measure the intensity of force incurred by the touch.

The audio module 170 may convert a sound into an electrical signal and vice versa. The audio module 170 may obtain the sound via the input device 150, or output the sound via the sound output device 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. The sensor module 176 may include a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. The interface 177 may include a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). The connecting terminal 178 may include an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. The haptic module 179 may include, for example, a motor, a piezoelectric element, or an electric stimulator.

The camera module 180 may capture a still image or moving images. The camera module 180 may include one or more lenses, image sensors, image signal processors, or flashes. The power management module 188 may manage power supplied to the electronic device 101. The power management module 188 may be implemented as at least part of a power management integrated circuit (PMIC).

The battery 189 may supply power to at least one component of the electronic device 101. The battery 189 may include a primary cell which is not rechargeable, a secondary cell which is rechargeable, and/or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the AP) and supports a direct (e.g., wired) communication or a wireless communication. The communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a cellular network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., an international mobile subscriber identity (IMSI)) stored in the SIM 196.

The antenna module 197 may transmit or receive a signal or power to or from the outside (e.g., the external electronic device) of the electronic device 101. The antenna module 197 may include an antenna including a radiating element composed of a conductive material or a conductive pattern formed in or on a substrate (e.g., a printed circuit board (PCB)). The antenna module 197 may include a plurality of antennas. In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. Another component (e.g., a radio frequency integrated circuit (RFIC)), other than the radiating element, may be additionally formed as part of the antenna module 197. At least some of the above-described components may be coupled mutually and communicate signals (e.g., commands or data) therebetween via an inter-peripheral communication scheme (e.g., a bus, general purpose input and output (GPIO), a serial peripheral interface (SPI), or a mobile industry processor interface (MIPI)).

Commands or data may be transmitted or received between the electronic device 101 and the external electronic device 104 via the server 108 coupled with the second network 199. Each of the electronic devices 102 and 104 may be a device of a same type as, or a different type, from the electronic device 101. All or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, or client-server computing technology may be used, for example.

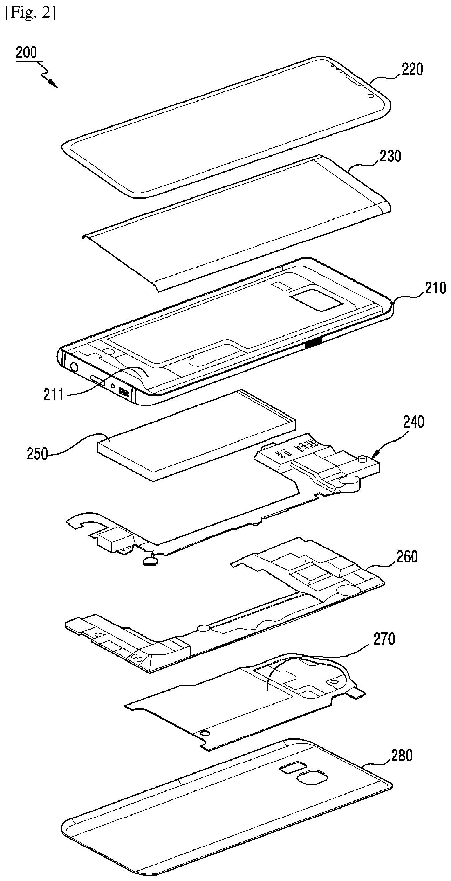

FIG. 2 illustrates an electronic device according to an embodiment.

Referring to FIG. 2, an electronic device 200 (e.g., the electronic device 101 of FIG. 1) may include a side bezel structure 210, a first support member 211 (e.g., a bracket), a front plate 220, a display 230, a printed circuit board 240, a battery (or a battery pack) 250 (e.g., the battery 189 of FIG.1), a second support member 260 (e.g., a rear case), an antenna 270 (e.g., the antenna module 197 of FIG. 1), and a rear plate 280. Alternatively, at least one of the components (e.g., the first support member 211 or the second support member 260) may be omitted from the electronic device 200, or the electronic device 200 may additionally include other components.

The electronic device 200 may include a housing including a front face, a rear face, and a side face surrounding a space between the front face and the rear face. The term, housing may refer to a structure forming some of the front face, the rear face, and the side face. At least a portion of the front face may be formed by a substantially transparent front plate 220 (e.g., a glass plate or a polymer plate including various coating layers). The rear face may be formed of a substantially opaque rear plate 280. The rear plate 280 may be formed of coated or colored glass, ceramic, a polymer, or a metal (e.g., aluminum, stainless steel (STS), or magnesium), or a combination of two or more of these materials. The side faces may be formed by a side bezel structure (or a "side member") 210 coupled to the front plate 220 and the rear plate 280 and including a metal and/or a polymer. Alternatively, the rear plate 280 and the side bezel structure 210 may be integrally formed, and may include the same material (e.g., a metal material such as aluminum).

The first support member 211 may be disposed inside the electronic device 200 and connected to the side bezel structure 210 or may be formed integrally with the side bezel structure 210. The first support member 211 may be formed of a metal material and/or a non-metal (e.g., polymer) material. The display 230 may be coupled to one face of the first support member 211, and the PCB 240 may be coupled to the other face of the first support member 211. On the PCB 240, a processor, a memory, and/or an interface may be mounted. The processor (e.g., the processor 120 of FIG. 1) may include at least one of a CPU, an AP, a GPU, an ISP, a sensor hub processor, or a CP.

The memory may include a volatile memory or a nonvolatile memory.

The interface may include an HDMI, a USB interface, an SD card interface, and/or an audio interface. The interface may electrically or physically connect the electronic device 200 to an external electronic device, and may include a USB connector, an SD card/an MMC connector, or an audio connector.

The battery 250 supplies power to at least one component of the electronic device 200, and may include a non-rechargeable primary battery, a rechargeable secondary battery, and/or a fuel cell. At least a part of the battery 250 may be disposed to be substantially flush with the PCB 240. The battery 250 may be integrally disposed within the electronic device 200, or may be mounted to be detachable from the electronic device 200. The battery 250 may be a pouch type battery, in which a battery cell is embedded in a pouch type case of an aluminum laminated sheet. The battery 250 may be a jelly-roll type (a rolling type) or a stack type. Alternatively, the battery 250 may be a combination type of the jelly-roll type and the stack type.

The antenna 270 may be disposed between the rear plate 280 and the battery 250. The antenna 270 may include a near-field Communication (NFC) antenna, a wireless charging antenna, and/or a magnetic secure transmission (MST) antenna. The antenna 270 may perform short-range communication with an external device, or may transmit/receive power required for charging in a wireless manner to/from the external device. Alternatively, an antenna structure may be formed by the side bezel structure 210, a part of the first support member 211, or a combination thereof.

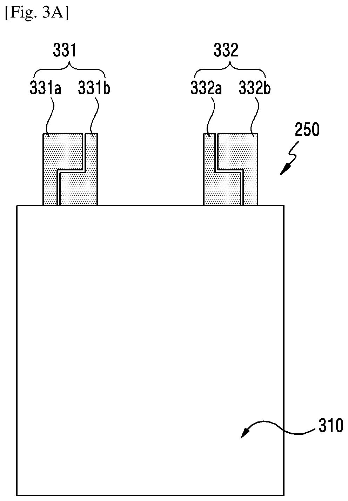

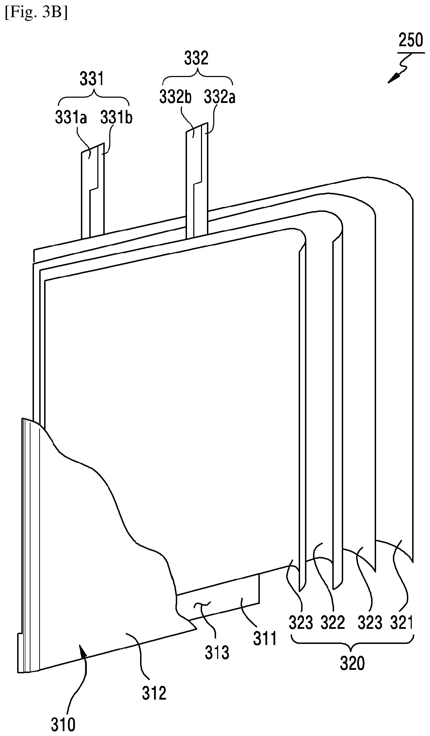

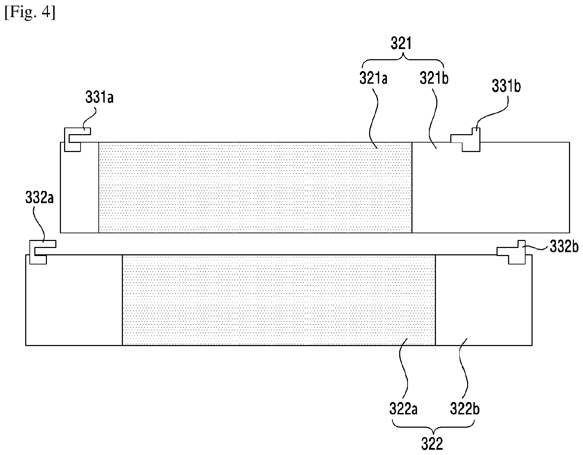

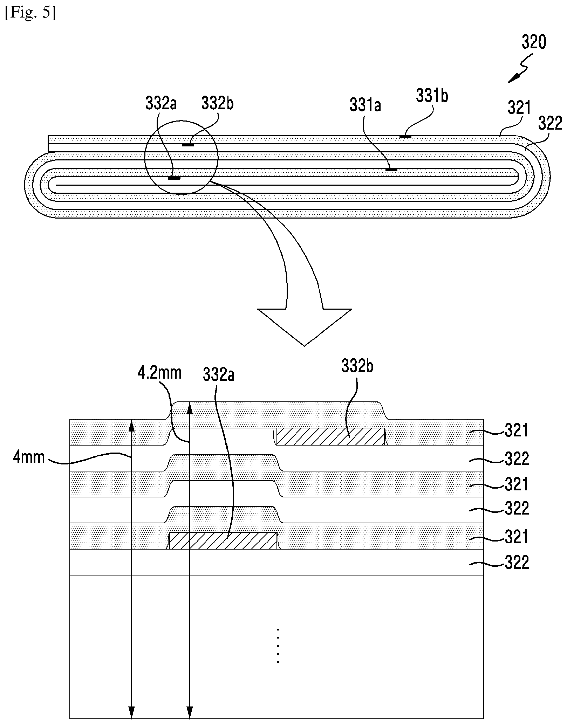

FIG. 3A illustrates an external appearance of a battery according to an embodiment. FIG. 3B illustrates an internal structure of a battery according to an embodiment. FIG. 4 illustrates a battery cell before rolling according to an embodiment. FIG. 5 illustrates a cross-sectional view of a battery cell in a rolling state according to an embodiment.

Referring to FIGs. 3A to 5, a battery 250 may include a pouch 310, a battery cell 320, a cathode tab 331, and an anode tab 332.

The pouch 310 (or a can) is a structure that provides an inner space 313, in which the battery cell 320 is accommodated. A first plate 311 and a second plate 312 are disposed to be spaced apart from each other to define the inner space 313. The pouch 310 may be formed of a metal such as aluminum or an aluminum alloy.

The battery cell 320 is provided by overlapping a cathode (or a cathode plate) 321, an anode (an anode plate) 322, and a separator 323 and winding them together. The battery cell 320 may have a jelly-roll form. Through a series of processes of disposing the battery cell 320 in the inner space 313 of the pouch 310, injecting an electrolyte into the inner space 313, and sealing the pouch 310, the battery cell 320 may be disposed in the inner space 313 of the pouch 310 together with the electrolyte.

The cathode 321 may include a cathode base and a first joining material coated on the cathode base. The cathode base may include a plate or a layer (e.g., aluminum foil) including a metal such as aluminum. The first joining material may include a cathode material, a conductive agent, and a binder. The cathode material may be a material (e.g., nickel cobalt aluminum (NCM), nickel cobalt aluminum (NCA), or a lithium cobalt oxide (LCO)) that is engaged in an electrode reaction, the conductive agent may be a material for increasing conductivity, and the binder may increase a coupling force of the cathode material and the conductive agent. The cathode material may include a lithium-based oxide.

Referring to FIG. 4, the cathode 321 may include a first coating area 321a coated with the first joining material and a first non-coating area 321b (e.g., a plain part) that is not coated with the first joining material. The first coating area 321a may be formed on opposite surfaces of the cathode 321, or may be formed on one surface of the cathode 321. The cathode tab 331 may be attached to the first non-coating area 321b. For example, a first cathode tab 331a is attached to a left end of the first non-coating area 321b, and a second cathode tab 331b may be attached to a right end of the first non-coating area 321b. The first cathode tab 331a and the second cathode tab 331b may be attached to portions (e.g., the first non-coating area 321b) of the cathode 321 by using an insulation tape.

The anode 322 may include an anode base and a second joining material coated on a surface of the anode base. The anode base may include a plate or a layer (e.g., copper foil) including a metal such as copper. The second joining material may include an anode material, a conductive agent, and a binder. The anode material may include carbon.

The cathode 322 may include a second coating area 322a coated with the second joining material and a second non-coating area 322b (e.g., a plain part) that is not coated with the second joining material. The second coating area 322a may be formed on opposite surfaces of the anode 322, or may be formed on one surface of the anode 322. The anode tab 332 may be attached to the second non-coating area 322b. For example, a first anode tab 332a may be attached to a left end of the second non-coating area 322b, and a second anode tab 332b may be attached to a right end of the first non-coating area 322b. The first anode tab 332a and the second anode tab 332b may be attached to portions (e.g., the second non-coating area 322b) of the anode 322 by using an insulation tape.

The electrolyte is injected into the pouch 310, and may be disposed in the interior of the pouch 310 together with the cathode tab 331 and the anode tab 332. The electrolyte is a medium that chemically balances an oxidation reaction or a reduction reaction that occurs in the cathode 321 or the anode 322, and may include a material in a liquid, solid, or gel state. For example, during charging of the battery 250, through oxidation of the cathode 321 and reduction of the anode 322, lithium ions generated in the cathode 321 move to the anode 322 via the electrolyte, and electrons may move from the cathode 321 to the anode 322 along a circuit (e.g., the power management module 188 of FIG. 1) connected to the cathode tab 331 and the anode tab 332. During discharging of the battery 250, through reduction of the cathode 321 and oxidation of the anode 322, lithium ions generated in the anode 322 move to the cathode 321 via the electrolyte, and electrons may move from the anode 322 to the cathode 321 along a circuit (e.g., the power management module 188 of FIG. 1) connected to the cathode tab 331 and the anode tab 332. During the discharging of the battery 250, the chemical energy of the cathode material of the cathode 321, the anode material of the anode 322, and the electrolyte may be converted to electric energy, and electric power may be supplied to the corresponding circuit through the cathode tab 331 connected to the cathode 321 and the anode tab 332 connected to the anode 322.

The separator 323 may be disposed between the cathode 321 and the anode 322 to prevent a physical contact between the cathode 321 and the anode 322. The separator 323 may prevent a short-circuit between the cathode 321 and the anode 322 and may allow ions to move. The separator 323 may allow the ion to move through fine holes to allow electric charges to flow, and may be formed of various materials to have porosity. The separator 323 may include at least one of polyethylene (PE) or polypropylene (PP). The separator 323 may be formed of a single layer including PE or PP, or may be formed of a dual layer in which a layer of PE and a layer of PP are joined to each other. As another example, the separator 323 may be formed of a triple layer in which a layer of PP, a layer of PE, and another layer of PP are joined to each other.

The cathode tab 331 may be electrically connected to the cathode 321, and may protrude (be exposed) to the outside of the cathode 321. The cathode tab 331 may include a plurality of tabs (e.g., the first cathode tab 331a and the second cathode tab 331b), and may be joined (e.g., through binding or welding) to the cathode terminal. The cathode tab 331 may include an area (i.e., a first area) that is not exposed to the outside when the cathode tab 331 contacts the cathode 321 and is rolled, and another area (i.e., a second area) that is exposed to the outside. The first cathode tab 331a and the second cathode tab 331b may be disposed in the cathode 321 such that the first areas do not overlap each other when viewed from the top of one surface (e.g., a front surface or a rear surface) of the battery cell 320. The second area of the cathode tab 331 may have an unstructured shape. That is, the shape of second area of the cathode tab 331 does not have a specific pattern or a regular pattern such as a structure shape (e.g., a rectangular shape or a tetragonal shape), but has a pattern having irregular shapes or irregular patterns.

The anode tab 332 may be electrically connected to the anode 322, and may protrude to the outside of the anode 322. The anode tab 332 may include a plurality of tabs (e.g., the first anode tab 332a and the second anode tab 332b), and may be joined (e.g., through binding or welding) to the anode terminal. The anode tab 332 may include an area (i.e., a third area) that contacts the anode 322 and is not exposed to the outside, and another area (i.e., a fourth area) that is exposed to the outside. The first anode tab 332a and the second anode tab 332b may be disposed in the anode 322 such that the third areas do not overlap each other when viewed from the top of one surface (e.g., a front surface or a rear surface) of the battery cell 320. The fourth area of the anode tab 332 may have an unstructured shape.

Referring to FIG. 5, the battery cell 320 may be rolled, such that the cathode tab 331 and the anode tab 332 may be disposed not to overlap each other when viewed from the vertically upper side in a state in which the battery cell 320 is rolled. Further, at least portions of the first cathode tab 331a and the second cathode tab 331b also may be disposed not to overlap each other. For example, first areas of the first cathode tab 331a and the second cathode tab 331b also may be disposed not to overlap each other. Similarly, at least portions of the first anode tab 332a and the second anode tab 332b also may be disposed not to overlap each other. For example, first areas of the first anode tab 332a and the second anode tab 332b may be disposed not to overlap each other. For convenience of description, FIG. 5 does not illustrate a separator 323 between the cathode 321 and the anode 322.

The battery 250 may minimize an increase in the thickness of the battery cell 320 by disposing the first areas of the first cathode tab 331a and the second cathode tab 331b and the third areas of the first anode tab 332a and the second anode tab 332b such that at least they do not overlap each other. For example, assuming that the thicknesses of the cathode 321 and the anode 322 are 0.4 mm and the thicknesses of the first cathode tab 331a, the second cathode tab 331b, the first anode tab 332a, and the second anode tab 332b are 0.2 mm, the vertical thickness of the battery cell 320 may be approximately 4.2 mm (= 0.4 * 10 (five cathodes and five anode are alternately stacked) + 0.2). For convenience of description, the thickness of the separator 323 is not considered.

Unlike FIG. 5, when the first cathode tab 331a, the second cathode tab 331b, the first anode tab 332a, and the second anode tab 332b are disposed such that at least portions thereof the overlap each other, the thickness of the battery cell 320 may increase by the number of the overlapping tabs. For example, when two tabs overlap each other, the thickness of the battery cell 320 increases by 0.2 mm as compared with the embodiment of FIG. 5, which has been described above whereby the vertical thickness of the battery cell 320 may become approximately 4.4 mm (= 4.2 mm + 0.2 mm). When four tabs overlap each other, the thickness of the battery cell 320 increases by 0.6 mm as compared with the embodiment of FIG. 5, which has been described above whereby the vertical thickness of the battery cell 320 may become approximately 4.8 mm (= 4.2 mm + 0.6 mm).

The above-structured battery 250 may convert chemical energy of the cathode 321 and the anode 322 to electric energy, and may supply the converted energy (electric power) to some configurations (e.g., the power management module 188) of the electronic device or receive energy from another configuration (e.g., a charging circuit) through the cathode tab 331 connected to the cathode 321 and the anode tab 332 connected to the anode 322. The cathode tab 331 and the anode tab 332 may be connected to some configurations of the electronic device through an electric circuit (e.g., a battery protecting circuit).

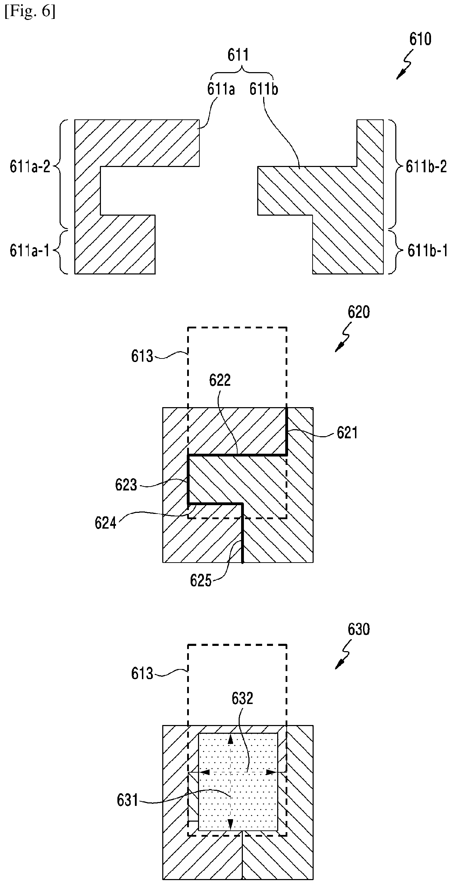

FIG. 6 illustrates a structure and a welding location of an electrode tab according to an embodiment.

Referring to FIG. 6, as illustrated in view 610, an electrode tab 611 (e.g., the cathode tab 331 or the anode tab 332) may include a first electrode tab 611a and a second electrode tab 611b, which have unstructured shapes. The first electrode tab 611a (e.g., the first cathode tab 331a or the first anode tab 332a) may include a first area 611a-1 attached to an electrode (e.g., the cathode 321 or the anode 322) that is not to be exposed to the outside and a second area 611a-2 exposed to the outside. Similarly, the second electrode tab 611b (e.g., the second cathode tab 331b or the second anode tab 332b) may include a third area 611b-1 attached to an electrode (e.g., the cathode 321 or the anode 322) that is not to be exposed to the outside and a fourth area 611b-2 exposed to the outside.

As illustrated in view 620, the first electrode tab 611a and the second electrode tab 611b may be coupled to each other to be formed as a single body. For example, a plurality of corners of the first electrode tab 611a and the second electrode tab 611b may be coupled to be engaged with each other like puzzle pieces.

View 620 illustrates an example in which five corners 621, 622, 623, 624, and 625 of the first electrode tab 611a and the second electrode tab 611b are coupled to engaged with each other. However, the disclosure is not limited thereto, and two to four corners of the first electrode tabs 611a and the second electrode tabs 611b may be engaged with each other, or six or more corners thereof may be engaged with each other.

In view 630, the first electrode tab 611a and the second electrode tab 611b formed as a single body may be coupled to the electrode terminal 613. The first electrode tab 611a and the second electrode tab 611b may be coupled to the electrode terminal 613 through ultrasonic welding or binding.

At least some of the corners of the first electrode tab 611a and the second electrode tab 611b having unstructured shapes, which are coupled to be engaged with each other, may have directions that are different from those of other corners. This helps disperse an external impact applied to a coupling portion of the first electrode tab 611a and the second electrode tab 611b to a plurality of directions. For example, the first electrode tab 611a and the second electrode tab 611b may include corners coupled (e.g., welded) in a first direction 631 (e.g., a longitudinal direction) and corners coupled in a second direction 632 (e.g., a transverse direction) in order to prevent the first electrode tab 611a and the second electrode tab 611b from being separated from each other due to an external impact (an impact that damages the coupling in the first direction) related to the first direction through coupling in the second direction when the external impact related to the first direction is generated. This may also prevent the first electrode tab 611a and the second electrode tab 611b from being separated from each other by an external impact (an impact that damages the coupling in the second direction) related to the second direction through coupling in the first direction when the external impact related to the second direction is generated.

Unlike FIG. 6, when the first electrode tab and the second electrode tab have structured shapes (e.g., a rectangular shape), the first electrode tab and the second electrode tab may be disposed in parallel in the second direction 632 and only the corners in the first direction 631 may be coupled to each other. The first electrode tab and the second electrode tab having structured shapes of the coupling structure may be vulnerable to an external impact related to the first direction. In contrast, the first electrode tab 611a and the second electrode tab 611b of FIG. 6 may be robust to both external impacts related to the first direction and/or the second direction.

Further, the first electrode tab 611a and the second electrode tab 611b having the unstructured shapes may be robust to an external impact because they have more coupled portions than the first electrode tab and the second electrode tab having structured shapes (i.e., the total length of the coupled portion is larger).

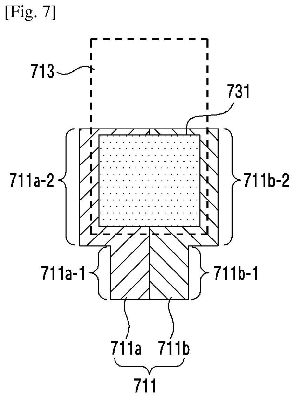

FIG. 7 illustrates a structure and a welding location of an electrode tab according to an embodiment.

Referring to FIG. 7, an electrode tab 711 (e.g., the cathode tab 331 or the anode tab 332) may include a first electrode tab 711a and a second electrode tab 711b, which have unstructured shapes. The first electrode tab 711a (e.g., the first cathode tab 331a or the first anode tab 332a) may include a first area 711a-1 attached to an electrode (e.g., the cathode 321 or the anode 322) not to be exposed to the outside and a second area 711a-2 exposed to the outside. Similarly, the second electrode tab 711b (e.g., the second cathode tab 331b or the second anode tab 332b) may include a third area 711b-1 attached to an electrode (e.g., the cathode 321 or the anode 322) not to be exposed to the outside and a fourth area 711b-2 exposed to the outside.

Because the extents of the second area 711a-2 and the fourth area 711b-2 of the electrode tab 711 are larger than the extents of the first area 711a-1 and the third area 711b-1, the area 731 coupled (e.g., welded) to the electrode terminal may be secured and coupling strength may be improved. The improvement of the coupling strength due to the securement of the coupling area 731 can prevent the first electrode tab 711a and the second tab 711b from being separated from each other by an external impact.

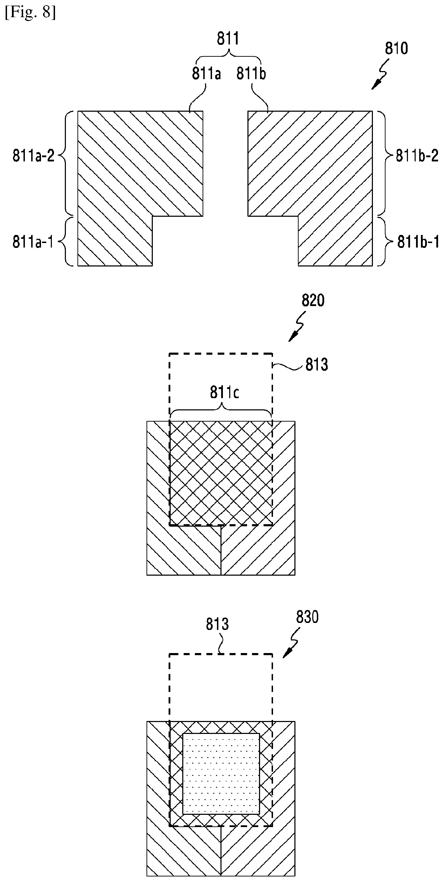

FIG. 8 illustrates a structure and a welding location of an electrode tab according to an embodiment of the disclosure.

Referring to FIG. 8, as illustrated in view 810, an electrode tab 811 (e.g., the cathode tab 331 or the anode tab 332) may include a first electrode tab 811a and a second electrode tab 811b, which have unstructured shapes. The first electrode tab 811a (e.g., the first cathode tab 331a or the first anode tab 332a) may include a first area 811a-1 attached to an electrode (e.g., the cathode 321 or the anode 322) not to be exposed to the outside and a second area 811a-2 exposed to the outside. Similarly, the second electrode tab 811b (e.g., the second cathode tab 331b or the second anode tab 332b) may include a third area 811b-1 attached to an electrode (e.g., the cathode 321 or the anode 322) not to be exposed to the outside and a fourth area 811b-2 exposed to the outside.

As illustrated in view 820, the first electrode tab 811a and the second electrode tab 811b may be coupled to each other to form a single body. For example, the first electrode tab 811a and the second electrode tab 811b may be coupled to each other such that some areas 811c overlap each other to be formed as a single body.

As illustrated in view 830, the coupled first electrode tab 811a and second electrode tab 811b may be joined to the electrode terminal 813. The first electrode tab 811a and the second electrode tab 811b may be coupled to the electrode terminal 813 through ultrasonic welding or binding. The overlapping areas 811c of the first electrode tab 811a and the second electrode tab 811b may be joined to each other. Accordingly, the coupling strength of the first electrode tab 811a and the second electrode tab 811b may be improved.

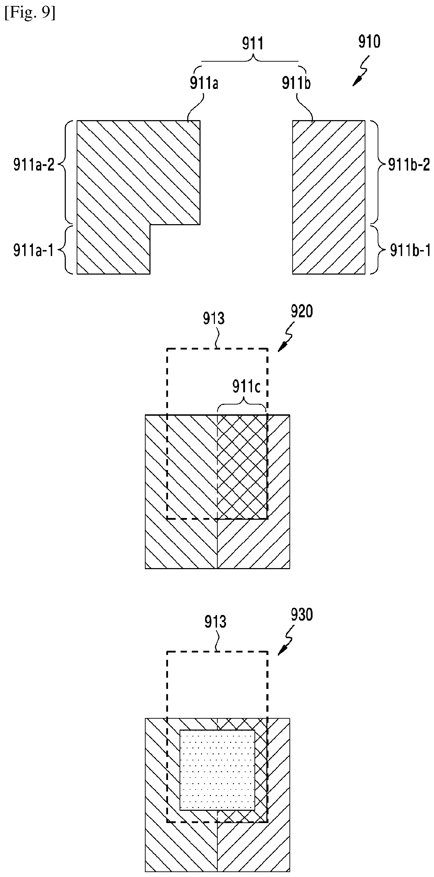

FIG. 9 illustrates a structure and a welding location of an electrode tab according to an embodiment.

Referring to FIG. 9, as illustrated in view 910, an electrode tab 911 (e.g., the cathode tab 331 or the anode tab 332) may include a first electrode tab 911a of a unstructured shape and a second electrode tab 911b of a structured shape. The first electrode tab 911a (e.g., the first cathode tab 331a or the first anode tab 332a) may include a first area 911a-1 attached to an electrode (e.g., the cathode 321 or the anode 322) not to be exposed to the outside and a second area 911a-2 exposed to the outside. Similarly, the second electrode tab 911b (e.g., the second cathode tab 331b or the second anode tab 332b) may include a third area 911b-1 attached to an electrode (e.g., the cathode 321 or the anode 322) not to be exposed to the outside and a fourth area 911b-2 exposed to the outside.

The electrode tab 911 of FIG. 9 is similar to the electrode tab 811 of FIG. 8, except that the shapes are different. For example, as illustrated in view 920, the first electrode tab 911a and the second electrode tab 911b may be coupled to each other such that some areas 911c thereof overlap each other.

As illustrated in view 930, the first electrode tab 911a and the second electrode tab 911b may be joined to the electrode terminal 913. Because the electrode tab 911 of FIG. 9 is coupled to the electrode terminal 913 and the areas 911c of the first electrode 911a and the second electrode tab 911b are joined to overlap each other, the coupling strength of the first electrode tab 911a and the second electrode tab 911b may be improved.

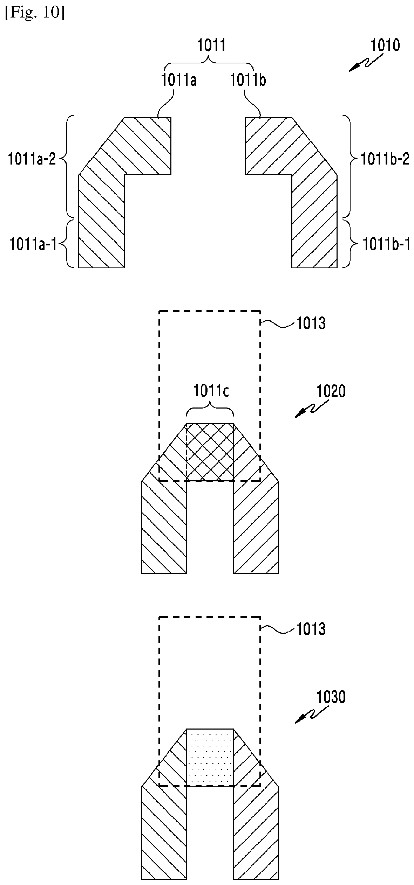

FIG. 10 illustrates a structure and a welding location of an electrode tab according to an embodiment.

Referring to FIG. 10, as illustrated in view 1010, an electrode tab 1011 (e.g., the cathode tab 331 or the anode tab 332) may include a first electrode tab 1011a and a second electrode tab 1011b, which have unstructured shapes. The first electrode tab 1011a (e.g., the first cathode tab 331a or the first anode tab 332a) may include a first area 1011a-1 attached to an electrode (e.g., the cathode 321 or the anode 322) not to be exposed to the outside and a second area 1011a-2 exposed to the outside. Similarly, the second electrode tab 1011b (e.g., the second cathode tab 331b or the second anode tab 332b) may include a third area 1011b-1 attached to an electrode (e.g., the cathode 321 or the anode 322) not to be exposed to the outside and a fourth area 1011b-2 exposed to the outside.

The electrode tab 1011 of FIG. 10 is similar to the electrode tab 811 of FIG. 8, except that the shapes thereof are different. For example, as illustrated in view 1020, the first electrode tab 1011a and the second electrode tab 1011b may be coupled to each other such that some areas 1011c thereof overlap each other.

As illustrated in view 1030, the first electrode tab 1011a and the second electrode tab 1011b may be joined to the electrode terminal 1013. Because the electrode tab 1011 of FIG. 10 is coupled to the electrode terminal 1013 and the areas 1011c of the first electrode 1011a and the second electrode tab 1011b are matched to overlap each other, the coupling strength of the first electrode tab 1011a and the second electrode tab 1011b may be improved.

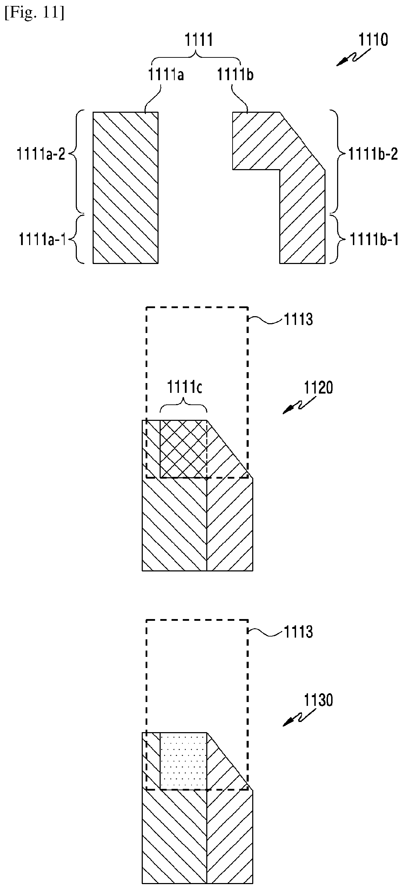

FIG. 11 illustrates a structure and a welding location of an electrode tab according to an embodiment.

Referring to FIG. 11, as illustrated in view 1110, an electrode tab 1111 (e.g., the cathode tab 331 or the anode tab 332) may include a first electrode tab 1111a and a second electrode tab 1111b, which have unstructured shapes. The first electrode tab 1111a (e.g., the first cathode tab 331a or the first anode tab 332a) may include a first area 1111a-1 attached to an electrode (e.g., the cathode 321 or the anode 322) not to be exposed to the outside and a second area 1111a-2 exposed to the outside. Similarly, the second electrode tab 1111b (e.g., the second cathode tab 331b or the second anode tab 332b) may include a third area 1111b-1 attached to an electrode (e.g., the cathode 321 or the anode 322) not to be exposed to the outside and a fourth area 1111b-2 exposed to the outside.

The electrode tab 1111 of FIG. 11 is similar to the electrode tab 811 of FIG. 8, except that the shapes thereof are different. For example, as illustrated in view 1120, the first electrode tab 1111a and the second electrode tab 1111b may be coupled to each other such that some areas 1111c thereof overlap each other.

As illustrated in view 1130, the first electrode tab 1111a and the second electrode tab 1111b may be joined to the electrode terminal 1113. Because the electrode tab 1111a of FIG. 11 is coupled to the electrode terminal 1113 and the areas 1111c of the first electrode 1111a and the second electrode tab 1111b are matched to overlap each other, the coupling strength of the first electrode tab 1111a and the second electrode tab 1111b may be improved.

As described above, the coupling strengths (e.g., the welding strengths) of the electrode tabs 611, 711, 811, 911, 1011, and 1111 of the unstructured structures described in FIGs. 6 to 11 can be improved by increasing the joining extents of the first electrode tabs 611a, 711a, 811a, 911a, 1011a, and 1111a and the second electrode tabs 611b, 711b, 811b, 911b, 1011b, and 1111b, by configuring the first electrode tabs 611a, 711a, 811a, 911a, 1011a, and 1111a and the second electrode tabs 611b, 711b, 811b, 911b, 1011b, and 1111b such that at least portions of the areas exposed to the outside overlap each other, or by coupling the corners of a plurality of directions such that the corners are engaged with each other.

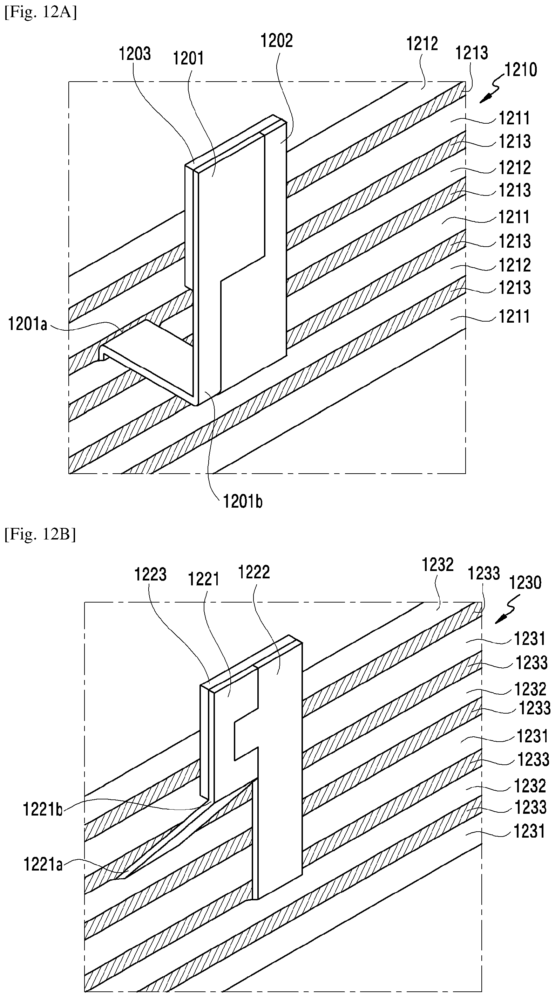

FIG. 12A illustrates a coupling structure of a plurality of electrode tabs according to an embodiment.

Referring to FIG. 12A, a battery cell 1210 (e.g., the battery cell 320) may include a first electrode tab 1201 (e.g., the first cathode tab 331a or the first anode tab 332a), a second electrode tab 1202 (e.g., the second cathode tab 331b or the second anode tab 332b), an electrode terminal 1203, a first electrode 1211 (e.g., the cathode 321), a second electrode 1212 (e.g., the anode 322), and a separator 1213 (e.g., the separator 323).

The first electrode tab 1201 and the second electrode tab 1202 may be disposed in the first electrode 1211 or the second electrode 1212. Hereinafter, a description will be made with the assumption that the first electrode tab 1201 and the second electrode tab 1202 are disposed in the second electrode 1212. For example, the first electrode tab 1201 may be disposed to protrude at a first location of the second electrode 1212, and the second electrode tab 1202 may be disposed to protrude at a second location of the second electrode 1212.

The first electrode tab 1201 may include bending parts 1201a and 1201b. For example, the first electrode tab 1201 may include a first bending part 1201a that is bent at the first location of the second electrode 1212 and a second bending part 1201b that is bent around the second electrode tab 1202. The first bending part 1201a and the second bending part 1201b of the first electrode tab 1201 are bent by approximately 90 degrees, but the disclosure is not limited thereto and may be bent at various angles.

After the exposed part (the second area) of the first electrode tab 1201 is bent, it may be disposed in parallel to the exposed part (the fourth area) of the second electrode tab 1202 while not overlapping the exposed part of the second electrode tab 1202. At least portions of the second area of the first electrode tab 1201 and the fourth area of the second electrode tab 1202 may overlap each other, e.g., as illustrated in FIGs. 8 to 11.

The first electrode tab 1201 and the second electrode tab 1202 formed as a single body through bending may then be joined (through binding or welding) to the electrode terminal 1203.

FIG. 12B illustrates a coupling structure of a plurality of electrode tabs according to an embodiment.

Referring to FIG. 12B, a battery cell 1230 (e.g., the battery cell 320) may include a first electrode tab 1221 (e.g., the first cathode tab 331a or the first anode tab 332a), a second electrode tab 1222 (e.g., the second cathode tab 331b or the second anode tab 332b), an electrode terminal 1223, a first electrode 1231 (e.g., the cathode 321), a second electrode 1232 (e.g., the anode 322), and a separator 1233 (e.g., the separator 323).

The battery cell 1230 is similar to the battery cell 1210 of FIG. 12A, except that the battery cell 1230 may have a different shape of the first electrode tab 1221. For example, the first electrode tab 1221 may be disposed to protrude at the first location of the second electrode 1232 to be inclined toward the second electrode tab 122. The first electrode tab 1221 may be bent at a specific angle (less than about 30 degrees to 90 degrees) toward the second electrode tab 1222 at the first bending part 1221a, may be bent to be parallel to the second electrode tab 1222 at the second bending part 1221b, and may be integrally formed with the second electrode tab 1222. Because the other configurations of the battery cell 1230 are the same as FIG. 12A, a detailed description of the other configurations of the battery cell 1230 will be omitted to avoid a repeated description thereof.

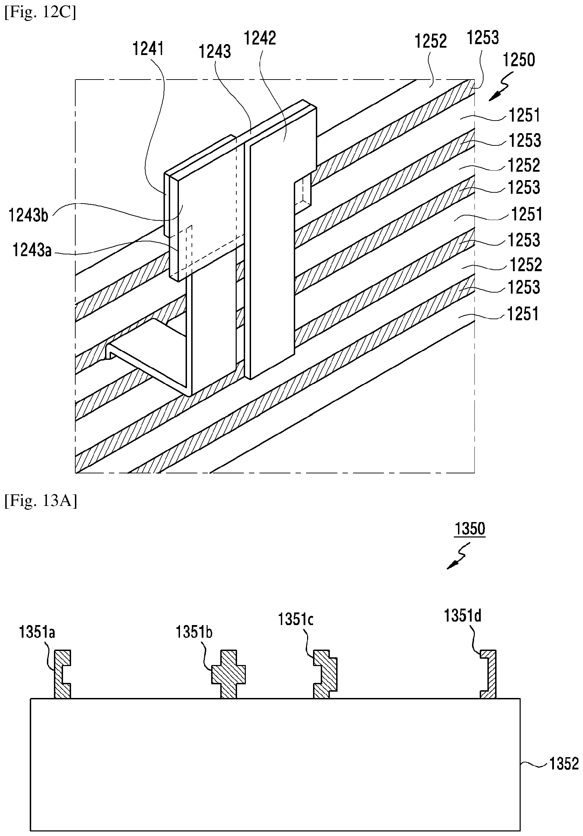

FIG. 12C illustrates a coupling structure of a plurality of electrode tabs according to an embodiment of the disclosure.

Referring to FIG. 12C, a battery cell 1250 (e.g., the battery cell 320) may include a first electrode tab 1241 (e.g., the first cathode tab 331a or the first anode tab 332a), a second electrode tab 1242 (e.g., the second cathode tab 331b or the second anode tab 332b), an electrode terminal 1243, a first electrode 1251 (e.g., the cathode 321), a second electrode 1252 (e.g., the anode 322), and a separator 1253 (e.g., the separator 323).

The battery cell 1250 is similar to the battery cell 1210 of FIG. 12A, except that the battery cell 1250 may be configured such that the electrode terminal 1243 is located between the first electrode tab 1241 and the second electrode tab 1242. For example, the first electrode tab 1241 may be joined to a first surface 1243a of the electrode terminal 1243, and the second electrode tab 1242 may be joined to a second surface 1243b of the electrode terminal 1243 located on an opposite side to the first surface 1243a. Because the other configurations of the battery cell 1250 are the same as FIG. 12A, a detailed description of the other configurations of the battery cell 1250 will be omitted to avoid a repeated description thereof.

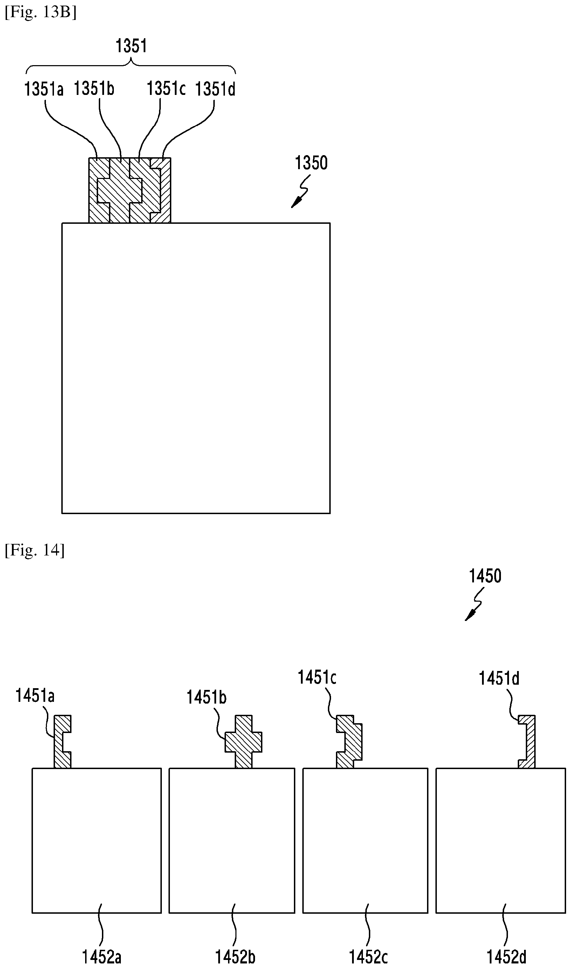

FIG. 13A illustrates a battery cell before rolling according to an embodiment. FIG. 13B illustrates a battery cell in a rolling state according to an embodiment.

Referring to FIGs. 13A and 13B, a battery cell 1350 may be configured such that three or more electrode tabs are coupled to each other to form one electrode tab 1351 (e.g., the cathode tab 331 or the anode tab 332).

As illustrated in FIG. 13B, the electrode tab 1351 may be formed by coupling four electrode tabs 1351a, 1351b, 1351c, and 1351d.

The four electrode tabs 1351a, 1351b, 1351c, and 1351d may include an area (a first area) that contacts the electrode 1352 and is not exposed to the outside and an area (a second area) that is exposed (or protrudes) to the outside.

The first areas of the fourth electrode tabs 1351a, 1351b, 1351c, and 1351d may be disposed in the electrode 1351 not to overlap each other when viewed from the top of one surface (e.g., a front surface or a rear surface) of the battery cell 1350 in a state in which the electrode 1352 is rolled. The second areas of the four electrode tabs 1351a, 1351b, 1351c, and 1351d have unstructured shapes, and are coupled to each other to form one electrode tab. The one electrode tab, in which the four electrode tabs 1351a, 1351b, 1351c, and 1351d having the unstructured shapes are coupled to each other, may be structured. The second areas, as illustrated in FIG. 13B, may not overlap each other.

At least some of the second areas, as illustrated in FIGs. 8 to 11, may overlap each other. For example, some areas of the first electrode tab 1351a and the second electrode tab 1351b may overlap each other, the second electrode tab 1351b and the third electrode tab 1351c may not overlap each other, and the third electrode tab 1351c and the fourth electrode tab 1351d may not overlap each other. Further, some areas of the first electrode tab 1351a and the second electrode tab 1351b may overlap each other, some areas of the second electrode tab 1351b and the third electrode tab 1351c may overlap each other, and some areas of the third electrode tab 1351c and the fourth electrode tab 1351d may overlap each other. Further, some areas of the first electrode tab 1351a and the second electrode tab 1351b may overlap each other, and some areas of the third electrode tab 1351c and the fourth electrode tab 1351d may overlap each other.

FIG. 14 illustrates a battery cell before stacking according to an embodiment.

Referring to FIG. 14, a battery cell 1450 may be of a stack type. In describing the stack type battery cell below, a configuration that is substantially the same as the configuration of the above-described jelly-roll type battery cell will be omitted, and only the differences will be described.

The battery cell 1450 may include first to fourth electrodes 1452a, 1452b, 1452c, and 1452d and first to fourth electrode tabs 1451a, 1451b, 1451c, and 1451d.

The first to fourth electrode tabs 1451a, 1451b, 1451c, and 1451d may be attached to (disposed in) the first to fourth electrodes 1452a, 1452b, 1452c, and 1452d. The first to fourth electrodes 1452a, 1452b, 1452c, and 1452d may be stacked to form one battery cell 1450. When the first to fourth electrodes 1452a, 1452b, 1452c, and 1452d are stacked, the first to fourth electrode tabs 1451a, 1451b, 1451c, and 1451d may be disposed to not overlap each other.

The first to fourth electrode tabs 1451a, 1451b, 1451c, and 1451d may include an area (i.e., a first area) that contacts the first to fourth electrodes 1452a, 1452b, 1452c, and 1452d and is not exposed to the outside and an area (i.e., a second area) that is exposed (protrudes) to the outside.

The first areas of the first to fourth electrode tabs 1451a, 1451b, 1451c, and 1451d may be disposed to not overlap each other when viewed from the top of one surface (e.g., a front surface or a rear surface) of the battery cell 1450. The second areas of the first to fourth electrode tabs 1451a, 1451b, 1451c, and 1451d have unstructured shapes, and are coupled to each other to form one electrode tab. The one electrode tab, in which the first to fourth electrode tabs 1451a, 1451b, 1451c, and 1451d having the unstructured shapes are coupled to each other may be structured. The second areas may not overlap each other. At least some areas of at least some of the second areas may overlap each other.

Although FIG. 14 illustrates the battery cell 1450 including the four electrodes 1452a, 1452b, 1452c, and 1452d and the four electrode tabs 1451a, 1451b, 1451c, and 1451d, the disclosure is not limited thereto. For example, the battery cell 1450 may include two, three, five, or more electrodes and electrode tabs.

Further, although FIG. 14 illustrates that the electrode tabs are attached to the four electrodes 1452a, 1452b, 1452c, and 1452d, respectively, the disclosure is not limited thereto. For example, the battery cell 1450 may be configured such that the electrode tabs are attached to two or more electrodes among the four electrodes 1452a, 1452b, 1452c, and 1452d. For example, the first electrode tab 1451a may be attached to the first electrode 1452a, the second electrode tab 1452b may not be attached to the second electrode 1452b, the third electrode 1452c may be attached to the third electrode tab 1451c, and the fourth electrode 1452d may not be attached to the fourth electrode tab 1451d.

According to an embodiment of the disclosure, a battery (e.g., the battery 189, 250) may include a pouch (e.g., the pouch 310); a battery cell (e.g., the battery cell 320, 1210, 1230, 1250, 1350, 1450) comprising a cathode (e.g., the cathode 321, the first electrode 1211, 1231, 1251), an anode (e.g., the anode 322, the second electrode 1212, 1232, 1252), and a separator (e.g., the separator 323) located between the cathode and the anode, and accommodated in the pouch; a plurality of cathode tabs (e.g., the first cathode tab 331a. the second cathode tab 331b, the first electrode tab 611a, 711a, 811a, 911a, 1011 a, 1111a, 1201, 1221, 1241), each of which comprises a first area electrically connected to the cathode and an unstructured second area extending to protrude from the first area to the outside of the cathode; a plurality of anode tabs (e.g., the first anode tab 32a, the second tab 32b, the second electrode tab 611b, 711b, 811b, 911b, 1011b, 1111b, 1202, 122, 1242) each of which comprises a third area electrically connected to the anode and an unstructured fourth area extending to protrude from the third area to the outside of the anode; a cathode terminal joined(or attached) to the second areas of the plurality of cathode tabs; and an anode terminal joined(or attached) to the fourth areas of the plurality of anode tabs. The cathode tabs are disposed in the cathode such that the first areas do not overlap each other when viewed from the top of one surface of the battery cell, and the second areas are coupled to each other as a single body. The anode tabs are disposed in the anode such that the third areas do not overlap each other when viewed from the top of one surface of the battery cell, and the fourth areas are coupled to each other as a single body.

The second areas of the plurality of cathode tabs may be coupled to each other such that at least portions thereof overlap each other, and the fourth areas of the plurality of anode tabs may be coupled to each other such that at least portions thereof overlap each other. The widths of the second areas of the plurality of cathode tabs and the fourth areas of the plurality of anode tabs may be larger than the widths of the first areas of the plurality of cathode tabs and the third areas of the plurality of anode tabs, respectively.

The second areas of the plurality of cathode tabs may be coupled to each other such that a plurality of corners (e.g., the corners 621, 622, 623, 624, 625) thereof are engaged with each other, and the fourth areas of the plurality of cathode tabs may be coupled to each other such that a plurality of corners (e.g., the corners 621, 622, 623, 624, 625) thereof are engaged with each other.

At least some of the plurality of corners of the cathode tabs may have different directions, and at least some of the corners of the anode tabs have different directions.

One side surface of the cathode terminal may be j oined to the second areas of the plurality of the cathode tabs, and one side surface of the anode terminal may be joined to the fourth areas of the plurality of the anode tabs.

The cathode terminal may be located between the plurality of cathode tabs such that opposite side surfaces thereof may be joined to the second areas of the plurality of cathode tabs, and the anode terminal may be located between the plurality of anode tabs such that opposite side surfaces thereof may be joined to the fourth areas of the plurality of anode tabs.

At least some of the plurality of cathode tabs may comprise one or more bending parts (e.g., the first bending part 1201a, 1221a, the second bending part 1201b, 1221b), and at least some of the plurality of anode tabs may comprise one or more bending parts (e.g., the first bending part 1201a, 1221a, the second bending part 1201b, 1221b).

The battery cell may include at least one of a jelly-roll type battery cell or a stack type battery cell.

The cathode terminal and the anode terminal may be respectively joined to the plurality cathode tabs and the plurality of anode tabs through binding or ultrasonic welding.

According to an embodiment, an electronic device (e.g., the electronic device 101, 200) may comprise a housing; a display (e.g., the display device 160, the display 230) viewed through at least a portion of the housing; and a battery (e.g., the battery 189, 250) disposed within the housing. The battery comprises a pouch (e.g., the pouch 310); a battery cell (e.g., the battery cell 320, 1210, 1230, 1250, 1350, 1450) comprising a cathode (e.g., the cathode 321, the first electrode 1211, 1231, 1251), an anode (e.g., the anode 322, the second electrode 1212, 1232, 1252), and a separator (e.g., the separator 323) located between the cathode and the anode, and accommodated in the pouch; a plurality of cathode tabs (e.g., the first cathode tab 331a, the second cathode tab 331b, the first electrode tab 611a, 711a, 811a, 911a, 1011a, 1111a, 1201, 1221, 1241), each of which comprises a first area electrically connected to the cathode and an unstructured second area extending to protrude from the first area to outside of the cathode; a plurality of anode tabs (e.g., the first anode tab 32a, the second tab 32b, the second electrode tab 611b, 711b, 811b, 911b, 1011b, 1111b, 1202, 122, 1242), each of which comprises a third area electrically connected to the anode and an unstructured fourth area extending to protrude from the third area to outside of the anode; a cathode terminal joined(or attached) to the second areas of the plurality of cathode tabs; and an anode terminal joined(or attached) to the fourth areas of the plurality of anode tabs. The cathode tabs are disposed in the cathode such that the first areas do not overlap each other when viewed from the top of one surface of the battery cell, and the second areas are coupled to each other as a single body. The anode tabs are disposed in the anode such that the third areas do not overlap each other when viewed from the top of one surface of the battery cell, and the fourth areas are coupled to each other as a single body.

The second areas of the plurality of cathode tabs may be coupled to each other such that at least portions thereof overlap each other, and the fourth areas of the plurality of anode tabs may be coupled to each other such that at least portions thereof overlap each other.

The widths of the second areas of the plurality of cathode tabs and the fourth areas of the plurality of anode tabs may be larger than the widths of the first areas of the plurality of cathode tabs and the third areas of the plurality of anode tabs, respectively.

The second areas of the plurality of cathode tabs may be coupled to each other such that a plurality of corners (e.g., the corners 621, 622, 623, 624, 625) thereof may be engaged with each other, and the fourth areas of the plurality of cathode tabs may be coupled to each other such that a plurality of corners (e.g., the corners 621, 622, 623, 624, 625) thereof may be engaged with each other.

At least some of the plurality of corners of the cathode tabs may have different directions, and at least some of the corners of the anode tabs have different directions.

One side surface of the cathode terminal may be j oined to the second areas of the plurality of the cathode tabs, and one side surface of the anode terminal may be joined to the fourth areas of the plurality of the anode tabs.

The cathode terminal may be located between the plurality of cathode tabs such that opposite side surfaces thereof may be joined to the second areas of the plurality of cathode tabs, and the anode terminal may be located between the plurality of anode tabs such that opposite side surfaces thereof may be joined to the fourth areas of the plurality of anode tabs.

At least some of the plurality of cathode tabs may comprise one or more bending parts (e.g., the first bending part 1201a, 1221a, the second bending part 1201b, 1221b), and at least some of the plurality of anode tabs may comprise one or more bending parts (e.g., the first bending part 1201a, 1221a, the second bending part 1201b, 1221b).

The battery cell may include at least one of a jelly-roll type battery cell or a stack type battery cell.

The cathode terminal and the anode terminal may be respectively joined to the plurality cathode tabs and the plurality of anode tabs through binding or ultrasonic welding.

According to the above-described embodiments, an increase in the thickness of the battery can be minimized by disposing the electrode tabs in the interior of the battery cell such that the electrode tabs do not overlap each other. Additionally, a battery of high capacity can be provided by securing a mounting space for a battery cell. Further, the electrode tabs can be prevented from being separated due to an external impact, such as a drop, by improving a coupling strength of the electrode tabs, thereby reinforcing battery safety.

An electronic device according to an embodiment may include a portable communication device (e.g., a smartphone), a computer device, a portable multimedia device, a portable medical device, a camera, a wearable device, or a home appliance. However, the electronic device is not limited to those above- described examples.

It should be appreciated that various embodiments of the disclosure and the terms used therein are not intended to limit the technological features set forth herein to particular embodiments and include various changes, equivalents, or replacements for a corresponding embodiment.

With regard to the description of the drawings, similar reference numerals may be used to refer to similar or related elements.

A singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and do not limit the components in other aspect (e.g., importance or order).

If an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, a module may be implemented in the form of an application-specific integrated circuit (ASIC).

Various embodiments as set forth herein may be implemented as software (e.g., the program 140) including one or more instructions that are stored in a storage medium (e.g., internal memory 136, or external memory 138) that is readable by a machine (e.g., the electronic device 101, 200). For example, a processor (e.g., the processor 120) of the machine (e.g., the electronic device 101, 200) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. The term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

A method according to an embodiment of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

Each component (e.g., a module or a program) of the above-described components may include a single entity or multiple entities. One or more of the above-described components may be omitted, or one or more other components may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. Operations performed by the module, the program, or another component may be carried out sequentially, in parallel, repeatedly, or heuristically, or one or more of the operations may be executed in a different order or omitted, or one or more other operations may be added.

## Claims

1. A battery (250), comprising:
a pouch (310);
a battery cell (320) comprising a cathode (321), an anode (322), and a separator (323) located between the cathode (321) and the anode (322), and accommodated in the pouch (310);
**characterized in**,
a plurality of cathode tabs (331; 331a, 331b), each of which comprises a first area electrically connected to the cathode (321) and an unstructured second area extending to protrude from the first area to outside of the cathode (321);
a plurality of anode tabs (332; 332a, 332b), each of which comprises a third area electrically connected to the anode (322) and an unstructured fourth area extending to protrude from the third area to outside of the anode (322);
a cathode terminal (613) joined to the second areas of the cathode tabs (331; 331a, 331b); and
an anode terminal (613) joined to the fourth areas of the anode tabs (332; 332a, 332b),
wherein the cathode tabs (331; 331a, 331b) are disposed in the cathode (321) such that the first areas do not overlap each other when viewed from the top of one surface of the battery cell (320), and the second areas are coupled to each other, and
wherein the anode tabs (332; 332a, 332b) are disposed in the anode (322) such that the third areas do not overlap each other when viewed from the top of one surface of the battery cell (320), and the fourth areas are coupled to each other.

2. The battery of claim 1, wherein the second areas (811a-2) of the cathode tabs (811a) are coupled to each other such that at least portions of the second areas (811a-2) overlap each other, and the fourth areas (811b-2) of the anode tabs are coupled to each other such that at least portions of the fourth areas overlap each other.

3. The battery of claim 1, wherein widths of the second areas (811a-2, 822b-2) of the cathode tabs and the fourth areas (811b-2, 611b-2) of the anode tabs are larger than widths of the first areas (611a-1, 611b-1) of the cathode tabs and the third areas (611a-1, 611b-1) of the anode tabs, respectively.

4. The battery of claim 1, wherein the second areas of the cathode tabs are coupled to each other such that a plurality of corners (621, 622, 623, 624, 625) of the cathode tabs are engaged with each other, and the fourth areas of the anode tabs are coupled to each other such that a plurality of corners (621, 622, 623, 624, 625) of the anode tabs are engaged with each other.

5. The battery of claim 4, wherein at least some of the corners (621, 622, 623, 624, 625) of the cathode tabs have different directions, and at least some of the corners (621, 622, 623, 624, 625) of the anode tabs have different directions.

6. The battery of claim 1, wherein a side surface of the cathode terminal (1203) is joined to the second areas of the cathode tabs (1201, 1202), and a side surface of the anode terminal (1203) is joined to the fourth areas of the anode tabs (1201, 1202).

7. The battery of claim 1, wherein the cathode terminal (1243) is located between the cathode tabs (1241, 1242) such that opposite side surfaces of the cathode terminal (1243) are joined to the second areas of the cathode tabs (1241, 1242), and the anode terminal (1243) is located between the anode tabs (1241, 1242) such that opposite side surfaces of the anode terminal (1243) are joined to the fourth areas of the anode tabs.

8. The battery of claim 1, wherein at least some of the cathode tabs (1203) comprise at least one bending part (1201a, 1201b), and
wherein at least some of the anode tabs (1203) comprise at least one bending part (1201a, 1201b).

9. The battery of claim 1, wherein the battery cell (320) includes at least one of a jelly-roll type battery cell or a stack type battery cell.

10. The battery of claim 1, wherein the cathode terminal and the anode terminal are respectively joined to the cathode tabs (331; 331a, 331b) and the anode tabs (332; 332a, 332b) through binding or ultrasonic welding.

11. An electronic device, comprising:
a housing;
a display (230); and
a battery (250) according to one of the claims 1 to 10 disposed within the housing.

## Patentansprüche

1. Batterie (250), umfassend:
einen Beutel (310);
eine Batteriezelle (320), die eine Kathode (321), eine Anode (322) und einen Separator (323) umfasst, der sich zwischen der Kathode (321) und der Anode (322) befindet und in dem Beutel (310) aufgenommen ist;
**gekennzeichnet durch**
eine Vielzahl von Kathodenfahnen (331; 331a, 331b), von denen jede einen ersten Bereich, der elektrisch mit der Kathode (321) verbunden ist, und einen unstrukturierten zweiten Bereich umfasst, der sich so erstreckt, dass er von dem ersten Bereich zur Außenseite der Kathode (321) vorsteht;
eine Vielzahl von Anodenfahnen (332; 332a, 332b), von denen jede einen dritten Bereich, der elektrisch mit der Anode (322) verbunden ist, und einen unstrukturierten vierten Bereich umfasst, der sich so erstreckt, dass er von dem dritten Bereich zur Außenseite der Anode (322) vorsteht;
einen Kathodenanschluss (613), der mit den zweiten Bereichen der Kathodenfahnen (331; 331a, 331b) verbunden ist; und
einen Anodenanschluss (613), der mit den vierten Bereichen der Anodenfahnen (332; 332a, 332b) verbunden ist,
wobei die Kathodenfahnen (331; 331a, 331b) in der Kathode (321) derart angeordnet sind, dass sich die ersten Bereiche von der Oberseite einer Oberfläche der Batteriezelle (320) aus gesehen nicht überlappen, und die zweiten Bereiche miteinander gekoppelt sind, und
wobei die Anodenfahnen (332; 332a, 332b) in der Anode (322) derart angeordnet sind, dass sich die dritten Bereiche von der Oberseite einer Oberfläche der Batteriezelle (320) aus gesehen nicht überlappen, und die vierten Bereiche miteinander gekoppelt sind.

2. Batterie nach Anspruch 1, wobei die zweiten Bereiche (811a-2) der Kathodenfahnen (811a) derart miteinander gekoppelt sind, dass sich zumindest Abschnitte der zweiten Bereiche (811a-2) überlappen, und die vierten Bereiche (811b-2) der Anodenfahnen derart miteinander gekoppelt sind, dass sich zumindest Abschnitte der vierten Bereiche überlappen.

3. Batterie nach Anspruch 1, wobei jeweils Breiten der zweiten Bereiche (811a-2, 822b-2) der Kathodenfahnen und der vierten Bereiche (811b-2, 611b-2) der Anodenfahnen größer sind als Breiten der ersten Bereiche (611a-1, 611b-1) der Kathodenfahnen und der dritten Bereiche (611a-1, 611b-1) der Anodenfahnen.

4. Batterie nach Anspruch 1, wobei die zweiten Bereiche der Kathodenfahnen derart miteinander gekoppelt sind, dass eine Vielzahl von Ecken (621, 622, 623, 624, 625) der Kathodenfahnen miteinander in Eingriff stehen, und die vierten Bereiche der Anodenfahnen derart miteinander gekoppelt sind, dass eine Vielzahl von Ecken (621, 622, 623, 624, 625) der Anodenfahnen miteinander in Eingriff stehen.

5. Batterie nach Anspruch 4, wobei mindestens einige der Ecken (621, 622, 623, 624, 625) der Kathodenfahnen unterschiedliche Richtungen haben und mindestens einige der Ecken (621, 622, 623, 624, 625) der Anodenfahnen unterschiedliche Richtungen haben.

6. Batterie nach Anspruch 1, wobei eine Seitenfläche des Kathodenanschlusses (1203) mit den zweiten Bereichen der Kathodenfahnen (1201, 1202) verbunden ist und eine Seitenfläche des Anodenanschlusses (1203) mit den vierten Bereichen der Anodenfahnen (1201, 1202) verbunden ist.

7. Batterie nach Anspruch 1, wobei der Kathodenanschluss (1243) zwischen den Kathodenfahnen (1241, 1242) derart angeordnet ist, dass gegenüberliegende Seitenflächen des Kathodenanschlusses (1243) mit den zweiten Bereichen der Kathodenfahnen (1241, 1242) verbunden sind, und der Anodenanschluss (1243) zwischen den Anodenfahnen (1241, 1242) derart angeordnet ist, dass gegenüberliegende Seitenflächen des Anodenanschlusses (1243) mit den vierten Bereichen der Anodenfahnen verbunden sind.

8. Batterie nach Anspruch 1, wobei mindestens einige der Kathodenfahnen (1203) mindestens einen Biegeteil (1201a, 1201b) umfassen, und
wobei mindestens einige der Anodenfahnen (1203) mindestens einen Biegeteil (1201a, 1201b) umfassen.

9. Batterie nach Anspruch 1, wobei die Batteriezelle (320) mindestens eine Batteriezelle vom Jelly-Roll-Typ oder eine Batteriezelle vom Stapeltyp enthält.

10. Batterie nach Anspruch 1, wobei der Kathodenanschluss und der Anodenanschluss jeweils durch Binden oder Ultraschallschweißen mit den Kathodenfahnen (331; 331a, 331b) und den Anodenfahnen (332; 332a, 332b) verbunden sind.

11. Elektronische Vorrichtung, umfassend:
ein Gehäuse;
eine Anzeige (230); und
eine Batterie (250) nach einem der Ansprüche 1 bis 10, die in dem Gehäuse angeordnet ist.

## Revendications

1. Batterie (250), comprenant :
une poche (310) ;
une cellule de batterie (320) comprenant une cathode (321), une anode (322), et un séparateur (323) situé entre la cathode (321) et l'anode (322), et logé dans la poche (310) ;
caractérisé en
une pluralité de languettes de cathode (331 ; 331a, 331b), chacune de celles-ci comprenant une première zone électriquement connectée à la cathode (321) et une deuxième zone non structurée s'étendant en saillie depuis la première zone jusqu'à l'extérieur de la cathode (321) ;
une pluralité de languettes d'anode (332 ; 332a, 332b), chacune de celles-ci comprenant une troisième zone électriquement connectée à l'anode (322) et une quatrième zone non structurée s'étendant en saillie depuis la troisième zone jusqu'à l'extérieur de l'anode (322) ;
une borne de cathode (613) reliée aux deuxièmes zones des languettes de cathode (331 ; 331a, 331b) ; et
une borne d'anode (613) reliée aux quatrièmes zones des languettes d'anode (332 ; 332a, 332b),
dans laquelle les languettes de cathode (331 ; 331a, 331b) sont disposées dans la cathode (321) de telle sorte que les premières zones ne se chevauchent pas l'une l'autre lorsqu'elles sont vues depuis le haut d'une surface de la cellule de batterie (320), et que les deuxièmes zones sont couplées l'une à l'autre, et
dans laquelle les languettes d'anode (332 ; 332a, 332b) sont disposées dans l'anode (322) de sorte que les troisièmes zones ne se chevauchent pas l'une l'autre lorsqu'elles sont vues depuis le haut d'une surface de la cellule de batterie (320), et que les quatrièmes zones sont couplées l'une à l'autre.

2. Batterie de la revendication 1, dans laquelle les deuxièmes zones (811a-2) des languettes de cathode (811a) sont couplées l'une à l'autre de sorte qu'au moins des parties des deuxièmes zones (811a-2) se chevauchent l'une l'autre, et les quatrièmes zones (811b-2) des languettes d'anode sont couplées l'une à l'autre de sorte qu'au moins des parties des quatrièmes zones se chevauchent l'une l'autre.

3. Batterie de la revendication 1, dans laquelle des largeurs des deuxièmes zones (811a-2, 822b-2) des languettes de cathode et des quatrièmes zones (811b-2, 611b-2) des languettes d'anode sont plus grandes que des largeurs des premières zones (611a-1, 611b-1) des languettes de cathode et des troisièmes zones (611a-1, 611b-1) des languettes d'anode, respectivement.

4. Batterie de la revendication 1, dans laquelle les deuxièmes zones des languettes de cathode sont couplées l'une à l'autre de sorte qu'une pluralité de coins (621, 622, 623, 624, 625) des languettes de cathode sont en prise l'un avec l'autre, et les quatrièmes zones des languettes d'anode sont couplées l'une à l'autre de sorte qu'une pluralité de coins (621, 622, 623, 624, 625) des languettes d'anode sont en prise l'un avec l'autre.

5. Batterie de la revendication 4, dans laquelle au moins certains des coins (621, 622, 623, 624, 625) des languettes de cathode ont des directions différentes, et au moins certains des coins (621, 622, 623, 624, 625) des languettes d'anode ont des directions différentes.

6. Batterie de la revendication 1, dans laquelle une surface latérale de la borne de cathode (1203) est jointe aux deuxièmes zones des languettes de cathode (1201, 1202), et une surface latérale de la borne d'anode (1203) est jointe aux quatrièmes zones des languettes d'anode (1201, 1202).

7. Batterie de la revendication 1, dans laquelle la borne de cathode (1243) est située entre les languettes de cathode (1241, 1242) de sorte que des surfaces latérales opposées de la borne de cathode (1243) sont jointes aux deuxièmes zones des languettes de cathode (1241, 1242), et la borne d'anode (1243) est située entre les languettes d'anode (1241, 1242) de sorte que les surfaces latérales opposées de la borne d'anode (1243) sont jointes aux quatrièmes zones des languettes d'anode.

8. Batterie de la revendication 1, dans laquelle au moins certaines des languettes de cathode (1203) comprennent au moins une partie de flexion (1201a, 1201b), et
dans laquelle au moins certaines des languettes d'anode (1203) comprennent au moins une partie de flexion (1201a, 1201b).

9. Batterie de la revendication 1, dans laquelle la cellule de batterie (320) comprend au moins l'une d'une cellule de batterie de type enroulé ou d'une cellule de batterie de type à empilement.

10. Batterie de la revendication 1, dans laquelle la borne de cathode et la borne d'anode sont respectivement reliées aux languettes de cathode (331 ; 331a, 331b) et aux languettes d'anode (332 ; 332a, 332b) par liaison ou soudage par ultrasons.

11. Dispositif électronique comprenant :
un boîtier;
un affichage (230) ; et
une batterie (250) selon l'une des revendications 1 à 10 disposée à l'intérieur du boîtier.
